(19) Europäisches Patentamt
European Patent Office
Office européen des brevets

(11) **EP 2 953 176 A1**

(12) **EUROPÄISCHE PATENTANMELDUNG**

(43) Veröffentlichungstag:
**09.12.2015 Patentblatt 2015/50**

(51) Int Cl.:
***H01L 33/58*** *(2010.01)*

(21) Anmeldenummer: **14170820.6**

(22) Anmeldetag: **02.06.2014**

(84) Benannte Vertragsstaaten:
**AL AT BE BG CH CY CZ DE DK EE ES FI FR GB
GR HR HU IE IS IT LI LT LU LV MC MK MT NL NO
PL PT RO RS SE SI SK SM TR**
Benannte Erstreckungsstaaten:
**BA ME**

(71) Anmelder: **Swarovski Energy GmbH
1010 Wien (AT)**

(72) Erfinder: **Gianordoli, Stefan
2500 Baden (AT)**

(74) Vertreter: **Fabry, Bernd
IP2 Patentanwalts GmbH
Schlossstrasse 523
41238 Mönchengladbach (DE)**

(54) **Beleuchtungsvorrichtung**

(57) Vorgeschlagen wird eine Beleuchtungsvorrichtung umfassend

(a) ein Leuchtelement,
(b) einen Träger sowie
(c) ein Primäroptikelement

die sich dadurch auszeichnet, dass

(i) das Leuchtelement (a) auf dem Träger (b) befindlich ist und

(ii) das Primäroptikelement (c) dergestalt auf dem Verbund aus Leuchtelement (a) und Träger (b) angeordnet ist, dass es die aus dem Leuchtelement austretende Strahlung aufnimmt, lenkt und in der gewünschten Lichtverteilung abstrahlt, wobei

(iii) das Primäroptikelement (c) aus hochbrechendem Glas gefertigt und

(iv) durch Ansprengen am Träger befestigt ist.

**Abbildung 2**
Linsentypen: a) Chip Scale Lens   b) Mushroom Lens   c) Conformal Lens

**Beschreibung**

**GEBIET DER ERFINDUNG**

Die Erfindung befindet sich auf dem Gebiet der Elektrotechnik und hat eine Beleuchtungsvorrichtung, speziell eine so genannte Flip-Chip LED, zum Gegenstand, die aus einem Verbund aus einem Leuchtelement und einem Träger ("LED Chip") sowie einem Primäroptikelement besteht sowie deren Verwendung zur Beleuchtung von Objekten.

**STAND DER TECHNIK**

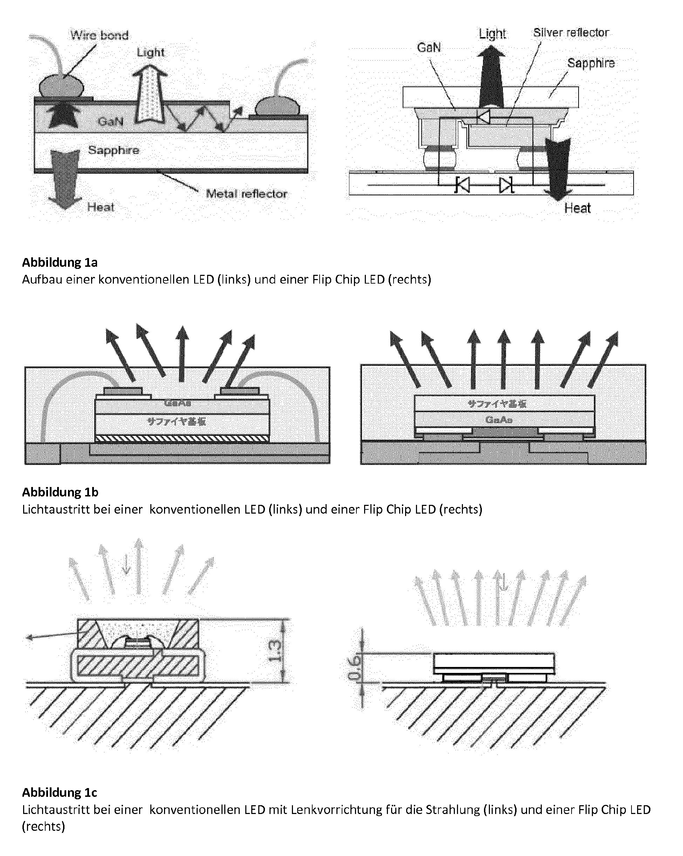

Unter Flip-Chip LED wird eine Technologie verstanden, bei der das Beleuchtungselement - üblicherweise eine LED -auf dem Kopf stehend montiert wird, wie dies in **Abbildung 1a** dargestellt ist. Erste Schutzrechte hierzu gehen auf Matsushita zurück (z.B. JP 57 092881 A1**)** und datieren aus den frühen 80er Jahren des vergangenen Jahrhunderts. Heute gibt es mehr als 1000 Patentveröffentlichungen zu diesem Thema

FC LED weisen gegenüber den konventionellen Produkten eine Reihe von wichtigen Vorteilen auf, insbesondere gewährleisten sie eine schnellere Wärmeableitung, was die Lebensdauer signifikant erhöht. FC LED benötigen auch keine Vorrichtungen, um das Licht in eine bestimmte Richtung zu lenken und gewährleisten auch bei Reflexion eine hohe Bildhelligkeit, wie dies schematisch in den **Abbildungen 1b und 1c** wiedergegeben ist.

Ein weiterer wichtiger Gesichtspunkt ist, dass sich FC LED leichter und schneller herstellen lassen, weil ausgehend vom Epi-Wafer nur noch ein "die bonding" sowie eine Modulierung erforderlich sind, um das Bauteil fertigzustellen. Damit werden also insbesondere das "wire bonding" und das Verkapseln des Leuchtstoffs eingespart.

Die Chips werden meist von transparenten linsenförmigen Hohlkörpern umhüllt, wobei als Material in aller Regel Kunststoffe, vor allem Polydimethylsiloxane eingesetzt werden. Diese haben sich speziell bei den bekannten und bewährten nitridbasierten Verbindungshalbleiterchips durchgesetzt, da sie die austretende Strahlung nicht absorbieren und daher keine oder nur sehr geringe Verschleißerscheinungen zeigen.

Silikone weisen jedoch ausgesprochen niedrige Brechungsindices auf, die typisch bei 1,40 bis 1,41 liegen. Dies bedeutet, dass zwischen dem Chip und der Umhüllung in der Regel ein erheblicher Unterschied im Brechungsindex besteht, der dazu führt, dass die Strahlungsauskopplung aus dem Chip stark verringert wird.

In der Vergangenheit hat man versucht, dieses Problem dadurch zu lösen, dass man die Polydimethylsiloxane chemisch modifiziert, beispielsweise durch den Einbau aromatischer Gruppen. Tatsächlich sind diese Ansätze eher kontraproduktiv, denn die Modifizierung der Siloxane führt im Ergebnis zu einer Zunahme bei der Absorption des aus dem Chip austretenden Lichtes in den Silikonkörper, so dass die austretende Strahlung nicht verstärkt, sondern verringert wird, das Silikongehäuse seine Transparenz zunehmen einbüßt und dadurch sich die Absorptionsverluste abermals erhöhen.

Ein weiterer Nachteil im Zusammenhang mit der Verwendung von Silikonen als Hüllkörper für FC LED ist, dass der Brechungsindex bei steigender Temperatur kleiner wird, dass sie eine hohe Permeabilität für Gase und Wasser aufweisen und nur eine geringe Härte besitzen.

Die Aufgabe der vorliegenden Erfindung hat somit darin bestanden, Beleuchtungsvorrichtungen vom Typ der Flip-Chip LED zur Verfügung zu stellen, die die geschilderten Nachteile des Stands der Technik überwinden. Insbesondere sollten die Bauteile mit Hüllkörpern ausgestattet sein, die einen ähnlichen Brechungsindex wie der Verbund aus Träger und Leuchtelement aufweisen, resistent gegen Temperatur- und Umwelteinflüsse sein, keine Permeabilität für Gase und Wasser aufweisen und eine höhe Härte als Polysiloxane besitzen.

**BESCHREIBUNG DER ERFINDUNG**

Gegenstand der Erfindung ist eine Beleuchtungsvorrichtung umfassend

(a) ein Leuchtelement,

(b) einen Träger sowie

(c) ein Primäroptikelement
die sich dadurch auszeichnet, dass

(i) das Leuchtelement (a) auf dem Träger (b) befindlich ist und

(ii) das Primäroptikelement (c) dergestalt auf dem Verbund aus Leuchtelement (a) und Träger (b) angeordnet ist, dass es die aus dem Leuchtelement austretende Strahlung aufnimmt, lenkt und in der gewünschten Lichtverteilung abstrahlt, wobei

(iii) das Primäroptikelement (c) aus hochbrechendem Glas gefertigt und

(iv) durch Ansprengen am Träger befestigt ist.

Überraschenderweise wurde gefunden, dass Primäroptikelemente, die aus einem hochbrechenden Glas gefertigt und direkt durch Ansprengen (auch als "direct bonding" oder "physical bonding" bezeichnet) am LED Chip befestigt sind, die Aufgabe voll umfänglich lösen. Zwischen dem Primäroptikelement und dem LED Chip befindet sich also keine gesonderte Verbindungsschicht, wie beispielsweise ein Klebstoff, da dies zu ähnlichen Problemen wie eingangs geschildert führen würde.

## LEUCHTELEMENTE

Auch wenn im Rahmen der vorliegenden Erfindung häufig von Flip Chip LED die Rede ist, weil dies bislang der *Terminus Technicus* für die vorliegende Technologie darstellt, so ist die Erfindung doch nicht auf die Ausführungsform des Leuchtelementes als LED beschränkt. Tatsächlich kann es sich dabei ebenso um eine OLED, eine LET oder eine OLET handeln.

## LED

LED, auch als Leuchtdioden bezeichnet, stellen lichtemittierende HalbleiterBauelemente dar, deren elektrische Eigenschaften denen einer Diode entspreche. Fließt durch die Diode elektrischer Strom in Durchlassrichtung, so strahlt sie Licht, IR-Strahlung und UV-Strahlung mit einer vom Halbleitermaterial und dessen Dotierung anhängigen Wellenlänge ab.
Der Halbleiterkristall vieler Leuchtdioden ist auf den Boden einer kegelförmigen Vertiefung in einem Metallhalter gelötet. Die Innenseiten der Vertiefung wirken als Reflektor für das aus den Seiten des Kristalls austretende Licht. Die Lötstelle bildet einen der beiden elektrischen Anschlüsse des Kristalls. Gleichzeitig nimmt sie die Abwärme auf, die entsteht, weil der Halbleiterkristall nur einen Teil der elektrischen Leistung in Licht umsetzt. Der Halter mit dem Reflektor ist bei bedrahteten Leuchtdioden als Draht mit rechteckigem Querschnitt ausgeführt, der als elektrischer Anschluss dient. Anders als sonst bei Elektronikbauteilen üblich besteht der Anschlussdraht nicht aus verzinntem Kupfer, sondern aus verzinntem Stahl. Die Wärmeleitfähigkeit von Stahl ist vergleichsweise gering. Dadurch wird der Halbleiterkristall beim Einlöten des Bauteils in eine Leiterplatte nicht durch Überhitzung zerstört. Die Oberseite des Kristalls ist nur durch einen dünnen Bonddraht elektrisch mit dem zweiten Stahlanschlussdraht verbunden, damit der Anschluss nur sehr wenig der lichtemittierenden Oberfläche verdeckt.
Hochleistungs-Leuchtdioden (H-LED) werden mit höheren Strömen als 20 Milliampere betrieben. Es entstehen besondere Anforderungen an die Wärmeableitung, die sich in speziellen Bauformen ausdrücken. Die Wärme kann über die Stromzuleitungen, die Reflektorwanne oder in den Leuchtdiodenkörper eingearbeitete Wärmeleiter abgeführt werden.
Weitere geeignete LED-Ausführungen, die im Sinne der vorliegenden Erfindung als Lichtquellen eingesetzt werden können, umfassen das direkte Drahtbonden des Leuchtdioden-Chips auf der Platine *(chip on board)* und der spätere Verguß mit Silikonmassen.
Die als Lichtquellen eingesetzten LED können auch mehrfarbig sein. Mehrfarbige Leuchtdioden bestehen aus mehreren (zwei oder drei) Dioden in einem Gehäuse. Meist haben sie eine gemeinsame Anode oder Kathode und einen Anschluss für jede Farbe. Bei einer Ausführung mit zwei Anschlüssen sind zwei Leuchtdioden-Chips antiparallel geschaltet. Je nach Polarität leuchtet die eine oder andere Diode. Eine quasi stufenlose Farbveränderung kann man über ein variables Pulsbreitenverhältnis eines geeigneten Wechselstroms realisieren.
Der prinzipielle Aufbau der Leuchtdioden der Erfindung entspricht dem einer pn-Halbleiterdiode; Leuchtdioden besitzen daher die gleichen Grundeigenschaften wie diese. Ein großer Unterschied besteht in dem verwendeten Halbleitermaterial. Während nichtleuchtende Dioden aus Silizium, seltener aus Germanium oder Selen hergestellt werden, ist das Ausgangsmaterial für Leuchtdioden ein direkter Halbleiter, meist eine Galliumverbindung als III-V-Verbindungshalbleiter.
Wird an eine Halbleiterdiode eine Spannung in Durchlassrichtung angelegt, wandern Elektronen von der n-dotierten Seite zum p-n-Übergang. Nach Übergang zur p-dotierten Seite geht das Elektron dann in das energetisch günstigere Valenzband über. Dieser Übergang wird Rekombination genannt, denn er kann auch als Zusammentreffen von einem Elektron im Leitungsband mit einem Defektelektron (Loch) interpretiert werden. Die bei der Rekombination frei werdende Energie kann in einem direkten Halbleiter als Licht (Photon) abgegeben werden.
Neben der direkten strahlenden Rekombination ist auch die Beteiligung von Exzitonen und Phononen möglich, was zu etwas weniger energiereicher Strahlung und zu einer Verschiebung des emittierten Lichtes in den längerwelligen Bereich führt. Dieser Mechanismus spielt insbesondere bei exzitonischer Emission in grünen Galliumphosphid-Leuchtdioden eine Rolle.

Die Bandstruktur des Halbleiters bestimmt unter anderem das Verhalten der Energieübertragung beim Übergang eines Elektrons vom Leitungs- ins Valenzband und entgegengesetzt. Bei den LED, die im Rahmen der vorliegenden Erfindung geeignet sind, kommen ausschließlich direkte Halbleiter in Betracht. Diese, zeichnen sich durch einen "direkten Bandübergang" aus, was bedeutet, dass die Elektronen am unteren Rand des Leitungsbands (Leitungsbandminimum) und am oberen Ende des Valenzbands (Valenzbandmaximum) denselben Impuls haben. Damit ist ein direkter Übergang des Elektrons unter Aussendung eines Photons (Licht) möglich, ohne dass ein Phonon zur Impulserhaltung beteiligt sein muss. Die Quantenausbeute des direkten Halbleiters GaAs liegt bei ca. 0.5, beim indirekten Halbleiter Si nur bei etwa $1.10^{-5}$.

Die Energie des emittierten Photons ist gleich der Energie der Bandlücke, also dem energetischen Abstand zwischen Leitungs- und Valenzband,

$$\lambda(W_{\mathbf{D}}) = \frac{h \cdot c}{W_{\mathbf{D}}} \qquad \text{mit} \quad W_{\mathbf{D}} = E'' - E'$$

wobei $\lambda_{(WD)}$ die Wellenlänge des emittierten Lichtes, h das Planck'sche Wirkungsquantum, c die Lichtgeschwindigkeit und $W_{\mathrm{D}}$ die Arbeit darstellt.

Die Größe der Bandlücke, also der Energielücke **E''-E'** bestimmt die Energie, das heißt, die Frequenz, Wellenlänge bzw. Farbe, des ausgesandten Lichtes. Sie lässt sich über die chemische Zusammensetzung des Halbleiters steuern. So verändert der Austausch von Atomen im Kristallgitter den kristallinen/molekularen Aufbau des Materials, u.a. seine Gitterparameter oder sogar seine Gitterstruktur. Beispielsweise hat der Halbleiter Galliumarsenid einen direkten Bandabstand von 1,4 eV, entsprechend einer Wellenlänge von 885 nm, d.h. im Nah-IR-Bereich. Die Zugabe von Phosphor vergrößert den Bandabstand, was das ausgesandte Licht energiereicher macht, wobei die Wellenlänge abnimmt und die Farbe von Infrarot zu Rot und Gelb übergeht. Durch die Zunahme von Phosphor im Kristall verformt sich jedoch auch das Leitungsband. Wenn Phosphor 50 Prozent der Arsen-Atome ersetzt, liegt der Bandabstand zwar bei fast zwei Elektronenvolt, was einer Strahlung von 650 nm (Rot) entspricht, dafür hat sich die Bandstruktur so verschoben, dass keine direkten Strahlungsübergänge mehr beobachtet werden, wie im Beispiel rechts gezeigt. Die Energie der Bandlücke spiegelt sich auch in der Höhe der Durchlassspannung der Diode wider. Bei langwelligem Licht liegt sie bei ca. 1.5 V, bei blauem Licht bei 3 V.

Durch die gezielte Auswahl der Halbleitermaterialien und der Dotierung können die Eigenschaften des erzeugten Lichtes variiert werden. Vor allem der Spektralbereich und die Effizienz lassen sich so beeinflussen:

- Aluminiumgalliumarsenid (AlGaAs) - rot (665 nm) und infrarot bis 1000 nm Wellenlänge

- Galliumarsenidphosphid (GaAsP) und Aluminiumindiumgalliumphosphid (AlInGaP)-rot, orange und gelb

- Galliumphosphid (GaP)-grün

- Siliziumkarbid (SiC)-erste kommerzielle blaue LED;

- Zinkselenid (ZnSe) - blauer Emitter;

- Indiumgalliumnitrid (InGaN)/Galliumnitrid (GaN) - Ultraviolett, Violett, blau und grün;

- Weiße LEDs, die im Sinne der vorliegenden Erfindung bevorzugt werden, sind meistens blaue LEDs mit einer davor befindlichen Lumineszenzschicht, die als Wellenlängen-Konverter wirkt.

Die erfindungsgemäße Beleuchtungsvorrichtung eignet sich besonders bevorzugt für nitridbasierte LED-Chips, kann jedoch ebenso bei anderen Chip-Typen, wie beispielsweise phosphidbasierte LED-Chips, welche beispielsweise GaP, AlP, InP, InGaP, AlGaP und/oder InGaAlP-Halbleiermaterial aufweisen, Einsatz finden. Solche LED-Chips sind unter anderem aus "Lighting your path to the future", Philips Lumileds Lighting Company, IMAPS November 2007 (abzurufen unter www.imaps.org/gbc/**IMAPS**07/GBC1_**PhilipsLumileds**.pdf) bekannt und werden von daher an dieser Stelle nicht mehr näher erläutert.

OLED

Eine besonders bevorzugte Lichtquelle im Sinne der Erfindung sind OLED. Dabei handelt es sich um organische Leuchtdioden, genauer gesagt um leuchtende Dünnschichtbauelemente aus organischen halbleitenden Materialien, das sich von den anorganischen Leuchtdioden (LED) dadurch unterscheiden, dass die elektrische Stromdichte und Leuchtdichte geringer und keine einkristallinen Materialien erforderlich sind. Im Vergleich zu herkömmlichen (anorganischen) Leuchtdioden lassen sich organische Leuchtdioden daher in Dünnschichttechnik kostengünstiger herstellen. OLEDs sind aus mehreren organischen Schichten aufgebaut. Dabei wird meist auf die Anode, bestehend aus Indium-Zinn-Oxid (ITO), die sich auf einer Glasscheibe befindet, eine Lochleitungsschicht (*hole transport layer,* HTL) aufgebracht. Zwischen ITO und HTL wird - abhängig von der Herstellungsmethode - oft noch eine Schicht aus PEDOT/PSS aufgebracht, die zur Absenkung der Injektionsbarriere für Löcher dient und die Eindiffusion von Indium in den Übergang verhindert. Auf die HTL wird eine Schicht aufgebracht, die entweder den Farbstoff enthält (ca. 5-10 %) oder-eher selten-vollständig aus dem Farbstoff besteht, z. B. Aluminium-tris(8-hydroxychinolin), Alq3. Diese Schicht bezeichnet man als Emitterschicht *(emitter layer,* EL). Auf diese wird optional noch eine Elektronenleitungsschicht (*electron transport layer,* ETL) aufgebracht. Zum Abschluss wird eine Kathode, bestehend aus einem Metall oder einer Legierung mit geringer Elektronenaustrittsarbeit wie zum Beispiel Calcium, Aluminium, Barium, Ruthenium, Magnesium-Silber-Legierung, im Hochvakuum aufgedampft. Als Schutzschicht und zur Verringerung der Injektionsbarriere für Elektronen wird zwischen Kathode und E(T)L meistens eine sehr dünne Schicht aus Lithiumfluorid, Cäsiumfluorid oder Silber aufgedampft.

Die Elektronen werden nun von der Kathode injiziert, während die Anode die "Löcher", d.h. die positive Ladung bereitstellt. Loch und Elektron driften aufeinander zu und treffen sich im Idealfall in der EL, weshalb diese Schicht auch Rekombinationsschicht genannt wird. Elektronen und Löcher bilden einen gebundenen Zustand, den man als Exziton bezeichnet. Abhängig vom Mechanismus stellt das Exziton bereits den angeregten Zustand des Farbstoffmoleküls dar, oder der Zerfall des Exzitons stellt die Energie zur Anregung des Farbstoffmoleküls zur Verfügung. Dieser Farbstoff hat verschiedene Anregungszustände. Der angeregte Zustand kann in den Grundzustand übergehen und dabei ein Photon (Lichtteilchen) aussenden. Die Farbe des ausgesendeten Lichts hängt vom Energieabstand zwischen angeregtem und Grundzustand ab und kann durch Variation der Farbstoffmoleküle gezielt verändert werden. Ein Problem stellen nichtstrahlende Triplett-Zustände dar. Diese können durch Zugabe von sogenannten "Exzitoren" wieder gelöst werden.

Anstelle der Licht emittierenden Dioden können auch entsprechende Transistoren verwendet werden, die als LET oder OLET bezeichnet werden.

## TRÄGER

Wie eingangs erläutert bilden das Leuchtelement (b) und der Träger (c) den sogenannt Chip bzw. LED Chip.

Die dem Primäroptikelement zugewandte Seite des Chips kann dabei, je nach zugrundeliegender Technologie und expliziter Ausgestaltung des LED-Chips, beispielsweise Saphir, SiC, GaN, InGaN, AlGaN, AlGaInN, Glas, Phosphor in Glas oder Phosphor in Keramik (man vergleiche diesbezüglich die in oben genannter Veröffentlichung, Seite 12, beschriebene TFFC LED mit Lumiramic™) aufweisen. Glas, Phosphor in Glas oder Phosphor in Keramik werden in diesem Zusammenhang als Bestandteil des LED-Chips gesehen.

## PRIMÄROPTIKELEMENTE

Bei dem Primäroptikelement handelt es sich vorzugsweise um eine Linse, speziell um eine Linse aus einem hochbrechenden Glas. Vorzugsweise besitzt das Element bzw. die Linse eine dem LED Chip zugewandte planare Ebene, während deren vom LED Chip abgewandte Seite eine die gewünschte Lichtverteilung erzeugende Kontur aufweist.

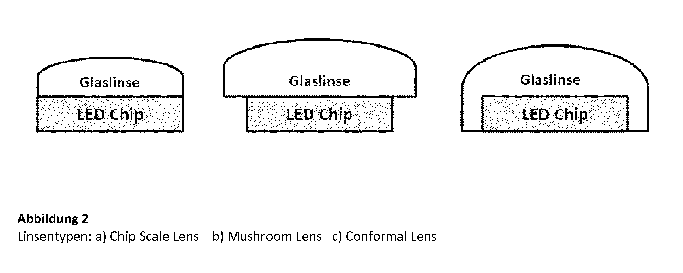

Das Primäroptikelement kann so ausgeführt sein, dass es im Wesentlichen nur die Oberfläche des LED Chips bedeckt ("chip scale lens" - **Abbildung** 2a). Diese Ausführung wird besonders dann gewählt, wenn das im LED-Chip erzeugte Licht im Wesentlichen durch die dem Primäroptikelement zugewandte Oberfläche abgestrahlt wird.

Das Primäroptikelement kann aber auch über den LED-Chip hinausragen ("mushroom lens" - **Abbildung** 2b) und an den über die Chipfläche hinausragenden Flächen Verankerungspunkte bilden.

In einer weiteren Ausführungsform kann das Primäroptikelement aber auch mit einer Aussparung in der dem LED-Chip zugewandten Seite ausgeführt werden, die den Chip aufnimmt. Durch diesen Weg der Einbettung des Chips in das Glas kann auch das an den Seitenflächen des Chips austretende Licht in den Glaskörper übertreten ("conformal lens"-**Abbildung 2c).**

## GLASZUSAMMENSETZUNG

Ein weiteres kritisches Merkmal der Erfindung betrifft die Zusammensetzung der Gläser, aus denen die Primäroptikelemente bzw. die Linsen bestehen. Dabei ist als erstes anzumerken, dass schon der Umstand, dass die Linsen überhaupt aus Glas und nicht wie inzwischen üblich aus Polysiloxan bestehen, für den technischen Erfolg der Erfindung mitverantwortlich ist. Nur mit Glaslinsen lassen sich so präzise Lichteinstrahlungen erreichen und nur mit Glaslinsen können auch die Anforderungen an die Beständigkeit erfüllt werden.

Es ist weiterhin erforderlich, dass die Gläser Oxide von vier-, zwei- und einwertigen Metallen aufweisen. Die vierwertigen Metalloxide sind dabei ausgewählt aus der Gruppe, die gebildet wird von Siliziumdioxid, Titandioxid und Zirkondioxid, sowie deren Mischungen.

Die zweiwertigen Metalloxide sind ausgewählt aus der Gruppe, die gebildet wird von Calciumoxid, Magnesiumoxid und Zinkoxid sowie deren Mischungen.

Die einwertigen Metalloxide sind ausgewählt aus der Gruppe, die gebildet wird von Natriumoxid, Kaliumoxid und Lithiumoxid sowie deren Mischungen.

Vorzugsweise sind die einzelnen Metalloxide in jeder der drei Gruppen in etwa gleichen Mengen enthalten. Ausnahme bildet die Gruppe der vierwertigen Metalloxide, in denen naturgemäß die Menge an Siliziumdioxid deutlich überragt. Es ist des Weiteren vorteilhaft, wenn die Gläser alle neuen ausdrücklich genannten Oxide enthalten.

Konkrete Beispiele für geeignete Glaszusammensetzungen sind in **Tabelle 1** offenbart. Besonders bevorzugte Zusammensetzungen umfassen:

(a1) etwa 58 bis etwa 63 Gew.-% vierwertige Metalloxide,

(a2) etwa 14 bis etwa 22 Gew.-% zweiwertige Metalloxide,

(a3) etwa 14 bis etwa 20 Gew.-% einwertige Metalloxide,

mit der Maßgabe, dass sich die Mengenangaben zu 100 Gew.-% addieren.

Eine weiter kritische Größe stellt der Brechungsindex $n_D$ dar, der vorzugsweise einen Wert von mindestens 1,6 und insbesondere mindestens 1,7 aufweist.

Die Gläser zeichnen sich zudem dadurch aus, dass bei Ausdehnungskoeffizienten von weniger als $10*10^{-6}$ $K^{-1}$, vorzugsweise $6 * 10^{-6}$ $K^{-1}$ und Schichtdicken von 10 mm im Spektralbereich von 400-800 nm Transmissionen von mindestens 85 %, bevorzugt mindestens 90 % erreicht werden.

Vorteilhafterweise besitzen die Gläser eine Dichte von etwa 2,65 bis etwa 2,75 $g/cm^3$ und insbesondere von etwa 2,68 bis 2,73 $g/cm^3$.

Ebenfalls bevorzugt sind Gläser, die eine definierte Vickershärte von etwa 600 bis etwa 650 HV 0,1/20 aufweisen.

## GLASHERSTELLUNG

Die Herstellung der speziellen Gläser der vorliegenden Erfindung kann in an sich bekannter Weise erfolgen; kritisch ist allein die Mischung der Einsatzstoffe, wie sie oben angegeben ist. Die Herstellung umfasst daher zunächst die Rauhschmelze, die das Einschmelzen des Gemenges und seine Homogenisierung umfasst, gefolgt von der Läuterung, bei die Gase ausgetrieben werden und schließlich das Abstehen, bei dem die Schmelze auf die gewünschte Formgebungstemperatur abgekühlt wird.

Das Gemenge wird der Schmelzwanne mit einer Einlegemaschine am Einlegevorbau, dem Doghouse, aufgegeben. Da das Gemenge eine geringere Dichte als die Glasschmelze besitzt, schwimmt dieses auf der Schmelze und bildet den sogenannten Gemengeteppich. Bei Temperaturen von ca. 1400 °C und mehr schmelzen die verschiedenen Bestandteile langsam auf. Einige der Gemengebestandteile können zusammen Eutektika bilden und bereits bei wesentlich geringeren Temperaturen erste Schmelzphasen bilden.Die Konvektion im Glasbad bewirkt einen kontinuierlichen Abtransport von Material, das sich vom Gemengeteppich löst. Gleichzeitig bewirkt sie eine Erwärmung des Gemenges. Somit erzeugt sie sowohl eine thermische, als auch eine chemische Homogenität der Schmelze.Diese kann durch ein Bubbling, die Eindüsung von Luft oder Gasen in die Schmelze, unterstützt werden.

Im Läuterbereich, der dem Schmelzbereich unmittelbar folgt, und häufig auch durch einen Wall in der Schmelze von diesem getrennt ist, werden in der Schmelze verbliebene Gase ausgetrieben. Zu diesem Zweck wird dem Gemenge zuvor ein sogenanntes Läutermittel zugegeben. Dieses Läutermittel zersetzt sich bei einer bestimmten Temperatur unter Gasbildung. Aufgrund von Partialdruckdifferenzen diffundieren nun Gase aus der Schmelze in die Läutermittel-Gasblasen ein, welche dadurch anwachsen und aufsteigen. Um diesen Prozess in wirtschaftlich vertretbaren Zeiten durchführen zu können, herrschen im Läuterteil einer Glasschmelzwanne ähnlich hohe Temperaturen wie im Schmelzteil, weil eine zu hohe Viskosität der Schmelze das Aufsteigen der Gasblasen stark verlangsamen würde. Da die Läuterung bestimmend für die Glasqualität ist, gibt es vielfältige unterstützende Maßnahmen.

Dem Läuterbereich schließt sich die baulich klar getrennte Arbeitswanne an. Da für die Formgebung niedrigere Temperaturen als zur Schmelze und Läuterung nötig sind, muss das Glas vorher abstehen. Daher spricht man auch von Abstehwanne. Der Kanal, der Schmelzwanne und Arbeitswanne verbindet, heißt Durchlass und arbeitet nach dem Siphonprinzip. Bei Flachglaswannen sind Schmelz- und Arbeitswanne nur durch eine Einschnürung getrennt, da ein Durchlass eine optische Unruhe im Fertigprodukt entstehen ließe.

Von der Arbeitswanne fließt das Glas weiter zum Entnahmepunkt, wo dann die Formgebung stattfindet. Bei der Produktion von Hohlglas sind dieses die Speiser oder Feeder. Hier werden Tropfen erzeugt, die über ein Rinnensystem in darunter stehende Glasmaschinen geleitet werden.

In jedem Glasgegenstand entstehen bei der Formgebung mechanische Spannungen als Folge einer Zwangsformgebung oder Dehnungsunterschiede im Material aufgrund von Temperaturgradienten. Diese Spannungen lassen sich mit optischen Spannungsprüfern unter polarisiertem Licht geometrisch messen (Spannungsdoppelbrechung). Die Spannungsanfälligkeit hängt vom Ausdehnungskoeffizienten des jeweiligen Glases ab und muss thermisch ausgeglichen werden.

Für jedes Glas lässt sich ein Kühlbereich festlegen, welcher von der so genannten oberen und unteren Kühltemperatur begrenzt wird. Die Lage dieser Temperaturen definiert sich nach der Viskosität, so ist die obere Kühltemperatur diejenige Temperatur bei der das Glas eine Viskosität von $10^{12}$ Pas besitzt. Bei der unteren Kühltemperatur liegt eine Viskosität 10 Pas vor. In der Regel erstreckt sich der Kühlbereich für die Gläser der vorliegenden Erfindung zwischen 590 °C und 450 °C. Die Spannungen verringert man durch Tempern, also durch definiertes langsames Abkühlen im Kühlbereich, da bei den hier vorherrschenden Viskositäten eine Spannungsrelaxation gerade noch möglich ist und bleibende Spannungen im Glaskörper vermieden werden.

Die Zeit, in der ein Glasgegenstand den Kühlbereich durchlaufen kann, hängt maßgeblich von der je nach Glasart zu überbrückenden Temperatur und der Stärke (Dicke) des Gegenstands ab. Im Hohlglasbereich sind dies zwischen 30 und 100 Minuten.

An diesen Vorgang kann sich die Veredlung der Glasoberfläche ansprechen. Unter einer Oberflächenveredelung versteht man sowohl das Aufbringen von Schichten als auch das Abtragen von Schichten, sowie das Modifizieren der Struktur oder der Chemie der Glasoberfläche. Sinn und Zweck solcher Maßnahmen ist die Verbesserung der bestehenden Gebrauchseigenschaften eines Glasgegenstandes oder die Erzeugung neuer Anwendungsgebiete für einen Glasgegenstand. Durch chemische und physikalische Gasphasenabscheidung können feinste Metallbeschichtungen aufgebracht werden. Die Beschichtung mit dielektrischem Material, das selbst durchsichtig ist, aber einen vom Glasträger abweichenden Brechungsindex aufweist, ermöglicht sowohl Verspiegelungen als auch eine Entspiegelung. Dies wird bei der Herstellung von Brillengläsern und Linsen für Fotoapparate eingesetzt, um störende Reflexionen zu vermindern. Für wissenschaftliche Zwecke werden Schichten hergestellt, die mehr als 99,9999 % des einfallenden Lichts einer bestimmten Wellenlänge reflektieren. Umgekehrt kann auch erreicht werden, dass 99,999 % des Lichts die Oberfläche passieren

Durch Sandstrahlen oder Behandlung mit Flusssäure kann die Oberfläche so weit aufgeraut werden, dass das Licht stark gestreut wird. Es erscheint dann milchig und nicht mehr durchsichtig, jedoch wird weiterhin nur sehr wenig Licht absorbiert. Daher wird diese Technik häufig für Lampenschirme oder blickdichte Fenster angewandt (siehe auch Satinieren). Ebenfalls mit Flusssäure lässt sich die Oberfläche eines Glases säurepolieren. Dabei werden die beschädigten Oberflächenschichten abgetragen was zu defektfreien Oberfläche und somit einer erhöhten Festigkeit des Glasgegenstandes führt. Eine weitere häufig eingesetzte Oberflächenveredelungsmethode ist die Entalkalisierung der Glasoberfläche. Durch Reaktion der heißen Glasoberfläche mit aggressiven Gasen (z. B. HCl oder $SO_2$) bilden sich mit den Alkalien aus dem Glas Salze, welche sich auf der Glasoberfläche abscheiden. Das an Alkalien verarmte Glas zeigt infolge dessen eine erhöhte chemische Beständigkeit.

Im Glas der Primäroptikelemente können des Weiteren einer oder mehrere Konversionsstoffe enthalten, beispielsweise homogen verteilt, sein, mittels derer die Primärstrahlung der LED Chips teilweise oder vollständig in Strahlung anderer Wellenlänge umgewandelt wird. Ebenso kann zusätzlich oder alternativ auf das Primäroptikelement ein Konversionsstoff aufgebracht sein. Alternativ kann auch die Glasrezeptur für das Primäroptikelement derart verändert werden, dass sich die nachträgliche Einbringung eines Konversionsstoffes in die Glasschmelze bzw. nachträgliche Aufbringung auf das Glaselement erübrigt. Die vergleichsweise hohe Wärmeleitfähigkeit von Glas mit einem Faktor 4 zu Kunststoff und die höhere Wärmediffusion mit einem Faktor 3 zu Kunststoff tragen zu der für die Konversionseffizienz entscheidenden Entwärmung des Konversionsstoffs bei. Als Konversionsstoffe eignen sich organische und anorganische Phosphore. Bevorzugt sind anorganische Phosphore, wie beispielsweise blau zu grün bis gelb konvertierende Phosphore auf der Basis von YAg:Ce, blau zu grün konvertierende Phosphore auf Basis von $(Ca,Sr)Ga_2S_4:Eu^{2+}$ oder blau zu rot konvertierende Phosphore auf der Basis von $(Ca,Sr)S:Eu^{2+}$.

**ANSPRENGEN**

Beim Ansprengen (auch Anschieben) werden zwei glatte, ebene Oberflächen nur durch deren molekulare Anziehungskräfte verbunden. Dazu müssen diese frei von Staub, Fett oder sonstigen Verschmutzungen sein. Kritisch für die vorliegende Erfindung ist daher, dass die zu verbindenden Oberflächen der Einheit aus dem Primäroptikelement (a) einerseits und dem Verbund aus Leuchtelement (b) und Träger (c) andererseits eine ausreichende Rauheit ($R_a$) und Ebenheit (PV) aufweisen.

Die Oberflächen sollten insbesondere eine Rauheit ($R_a$) von weniger als 10 nm und insbesondere weniger als 5 nm sowie vorzugsweise eine Ebenheit (PV) von weniger als 100 nm und insbesondere von weniger als 50 nm aufweisen.

Derartige Oberflächenqualitäten können beispielsweise mittels Schleifen und Polieren, mittels chemisch-mechanischem Polierens (CMP) und/oder mittels Säurepolierens erzielt werden. Speziell bevorzugt ist die Kombination aus nasschemischem Ätzen und Polieren.

## GEWERBLICHE ANWENDBARKEIT

Ein weiterer Gegenstand der Erfindung betrifft die Verwendung der erfindungsgemäßen Beleuchtungsvorrichtungen zur Ausleuchtung von Räumen. Dabei können die FC LED einzeln eingesetzt oder in Gruppen - beispielsweise auch in Gruppen auf einem Chip - angeordnet sein.

## BEISPIELE

### Beispiele 1 bis 5

Die Zusammensetzung verschiedener Gläser, die im Sinne der vorliegenden Erfindung zur Herstellung der optischen Linsen geeignet sind, sind in **Tabelle 1** wiedergegeben:

**Tabelle 1**

| Glaszusammensetzung | | | | | |
|---|---|---|---|---|---|
| **Komponente** | **1** | **2** | **3** | **4** | **5** |
| Siliziumdioxid | 60 | 55 | 50 | 50 | 50 |
| Titandioxid | 1 | 3 | 5 | 3 | 10 |
| Zirkondioxid | 1 | 2 | 5 | 5 | 2 |
| Calciumoxid | 10 | 10 | 10 | 12 | 10 |
| Magnesiumoxid | 3 | 5 | 13 | 3 | 10 |
| Zinkoxid | 3 | 5 | 5 | 6 | 5 |
| Natriumoxid | 10 | 6 | 6 | 7 | 9 |
| Kaliumoxid | 10 | 12 | 3 | 7 | 2 |
| Lithiumoxid | 2 | 2 | 3 | 7 | 2 |

## Patentansprüche

1. Beleuchtungsvorrichtung umfassend

    (a) ein Leuchtelement,
    (b) einen Träger sowie
    (c) ein Primäroptikelement

**dadurch gekennzeichnet, dass**

    (i) das Leuchtelement (a) auf dem Träger (b) befindlich ist und
    (ii) das Primäroptikelement (c) dergestalt auf dem Verbund aus Leuchtelement (a) und Träger (b) angeordnet ist, dass es die aus dem Leuchtelement austretende Strahlung aufnimmt, lenkt und in der gewünschten Lichtverteilung abstrahlt, wobei
    (iii) das Primäroptikelement (c) aus hochbrechendem Glas gefertigt und
    (iv) durch Ansprengen am Träger befestigt ist.

**2.** Vorrichtung nach Anspruch 1, **dadurch gekennzeichnet, dass** das Leuchtelement (a) ausgewählt ist aus der Gruppe, die gebildet wird von LED, OLED, LET und OLET.

**3.** Vorrichtung nach den Ansprüchen 1 und/oder 2, **dadurch gekennzeichnet, dass** es sich bei dem Leuchtelement (a) um eine nitridbasierte LED handelt.

**4.** Vorrichtung nach Anspruch 3, **dadurch gekennzeichnet, dass** es sich bei dem Leuchtelement (a) um LEDs handelt, die als Halbleiter GaP, AlP, InP, InGaP, AlGaP und/oder InGaAlP enthalten.

**5.** Vorrichtung nach mindestens einem der Ansprüche 1 bis 4, **dadurch gekennzeichnet, dass** das Leuchtelement (b) und der Träger (c) einen Chip darstellen.

**6.** Vorrichtung nach mindestens einem der Ansprüche 1 bis 5, **dadurch gekennzeichnet, dass** das Primäroptikelement (a) eine Linse darstellt.

**7.** Vorrichtung nach Anspruch 6, **dadurch gekennzeichnet, dass** die Linse einem dem Verbund aus Leuchtelement und Träger zugewandte planare Seite aufweist.

**8.** Vorrichtung nach mindestens einem der Ansprüche 1 bis 7, **dadurch gekennzeichnet, dass** das hochbrechende Glas einen Brechungsindex von $n_D$ von mindestens 1,6 besitzt.

**9.** Vorrichtung nach Anspruch 8, **dadurch gekennzeichnet, dass** das hochbrechende Glas einen Brechungsindex von $n_D$ von mindestens 1,7 besitzt.

**10.** Vorrichtung nach mindestens einem der Ansprüche 1 bis 9, **dadurch gekennzeichnet, dass** das hochbrechende Glas folgende Zusammensetzung aufweist
(a1) etwa 58 bis etwa 63 Gew.-% vierwertige Metalloxide,
(a2) etwa 14 bis etwa 22 Gew.-% zweiwertige Metalloxide,
(a3) etwa 14 bis etwa 20 Gew.-% einwertige Metalloxide,
mit der Maßgabe, dass sich die Mengenangaben zu 100 Gew.-% addieren.

**11.** Vorrichtung nach mindestens einem der Ansprüche 1 bis 10, **dadurch gekennzeichnet, dass** die zu verbindenden Oberflächen der Einheit aus dem Primäroptikelement (a) einerseits und dem Verbund aus Leuchtelement (b) und Träger (c) andererseits eine Rauheit ($R_a$) von weniger als 10 nm aufweisen.

**12.** Vorrichtung nach Anspruch 11, **dadurch gekennzeichnet, dass** die Oberflächen eine Rauheit ($R_a$) von weniger als 5 nm aufweisen.

**13.** Vorrichtung nach mindestens einem der Ansprüche 1 bis 12, **dadurch gekennzeichnet, dass** die zu verbindenden Oberflächen der Einheit aus dem Primäroptikelement (a) einerseits und dem Verbund aus Leuchtelement (b) und Träger (c) andererseits eine Ebenheit (PV) von weniger als 100 nm aufweisen.

**14.** Vorrichtung nach Anspruch 13, **dadurch gekennzeichnet, dass** die Oberflächen eine Ebenheit (PV) von weniger als 50 nm aufweisen.

**15.** Verwendung einer Vorrichtung nach mindestens einem der Ansprüche 1 bis 14 zur Ausleuchtung von Räumen.

EP 2 953 176 A1

**Abbildung 1a**
Aufbau einer konventionellen LED (links) und einer Flip Chip LED (rechts)

**Abbildung 1b**
Lichtaustritt bei einer  konventionellen LED (links) und einer Flip Chip LED (rechts)

**Abbildung 1c**
Lichtaustritt bei einer  konventionellen LED mit Lenkvorrichtung für die Strahlung (links) und einer Flip Chip LED (rechts)

**Abbildung 2**
Linsentypen: a) Chip Scale Lens    b) Mushroom Lens   c) Conformal Lens

Europäisches Patentamt
European Patent Office
Office européen des brevets

**EUROPÄISCHER RECHERCHENBERICHT**

Nummer der Anmeldung

EP 14 17 0820

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | US 2011/062469 A1 (CAMRAS MICHAEL D [US] ET AL) 17. März 2011 (2011-03-17) <br> * Absatz [0018]; Abbildung 2A * <br> * Absatz [0023] * <br> * Absatz [0019] * <br> * Absatz [0025] * <br> * Absatz [0005] * <br> * Absatz [0068] * <br> ----- | 1-15 | INV. <br> H01L33/58 |
| A | US 2012/153306 A1 (YAO ZHIMIN JAMIE [US]) 21. Juni 2012 (2012-06-21) <br> * Absatz [0045] * <br> * Absatz [0011] * <br> * Absatz [0031] - Absatz [0032] * <br> * Absatz [0049] - Absatz [0050] * <br> * Absatz [0052] * <br> * Absatz [0061] * <br> ----- | 1-15 | |
| A | US 2011/062471 A1 (BIERHUIZEN SERGE J [US] ET AL) 17. März 2011 (2011-03-17) <br> * Absatz [0005] * <br> * Absatz [0027] * <br> * Absatz [0044] * <br> ----- | 1-15 | RECHERCHIERTE SACHGEBIETE (IPC) <br><br> H01L |
| A | WO 2009/132837 A2 (SCHOTT AG [DE]; RINDT MATTHIAS [DE]; PAWLOWSKI EDGAR [DE]; ZETTERER TH) 5. November 2009 (2009-11-05) <br> * Ansprüche 1-12 * <br> ----- | 1-15 | |

Der vorliegende Recherchenbericht wurde für alle Patentansprüche erstellt

| Recherchenort | Abschlußdatum der Recherche | Prüfer |
|---|---|---|
| Den Haag | 21. Oktober 2014 | But, Gabriela-Ileana |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument
................................................................
& : Mitglied der gleichen Patentfamilie, übereinstimmendes Dokument

EPO FORM 1503 03.82 (P04C03)

**EP 2 953 176 A1**

**ANHANG ZUM EUROPÄISCHEN RECHERCHENBERICHT**
**ÜBER DIE EUROPÄISCHE PATENTANMELDUNG NR.**                    EP 14 17 0820

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

21-10-2014

| Im Recherchenbericht angeführtes Patentdokument | Datum der Veröffentlichung | Mitglied(er) der Patentfamilie | Datum der Veröffentlichung |
|---|---|---|---|
| US 2011062469 A1 | 17-03-2011 | CA 2774404 A1 | 24-03-2011 |
| | | CN 102484193 A | 30-05-2012 |
| | | EP 2478574 A2 | 25-07-2012 |
| | | JP 2013505571 A | 14-02-2013 |
| | | KR 20120082898 A | 24-07-2012 |
| | | TW 201121105 A | 16-06-2011 |
| | | US 2011062469 A1 | 17-03-2011 |
| | | WO 2011033406 A2 | 24-03-2011 |
| US 2012153306 A1 | 21-06-2012 | DE 112011104415 T5 | 26-09-2013 |
| | | US 2012153306 A1 | 21-06-2012 |
| | | WO 2012083217 A1 | 21-06-2012 |
| US 2011062471 A1 | 17-03-2011 | CN 102484191 A | 30-05-2012 |
| | | EP 2478575 A2 | 25-07-2012 |
| | | JP 2013505572 A | 14-02-2013 |
| | | KR 20120079105 A | 11-07-2012 |
| | | TW 201119098 A | 01-06-2011 |
| | | US 2011062471 A1 | 17-03-2011 |
| | | WO 2011033407 A2 | 24-03-2011 |
| WO 2009132837 A2 | 05-11-2009 | CN 102017201 A | 13-04-2011 |
| | | DE 102008021436 A1 | 20-05-2010 |
| | | EP 2272108 A2 | 12-01-2011 |
| | | JP 2011519173 A | 30-06-2011 |
| | | KR 20110016903 A | 18-02-2011 |
| | | US 2011205740 A1 | 25-08-2011 |
| | | WO 2009132837 A2 | 05-11-2009 |

EPO FORM P0461

Für nähere Einzelheiten zu diesem Anhang : siehe Amtsblatt des Europäischen Patentamts, Nr.12/82

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

* JP 57092881 A

**In der Beschreibung aufgeführte Nicht-Patentliteratur**

* Lighting your path to the future. Philips Lumileds Lighting Company, November 2007